# DEMANDE DE BREVET EUROPEEN

(11) **EP 1 892 535 A1**
(43) Date de publication de la demande: **27.02.2008**
(21) Numéro de dépôt: 07013250.1
(22) Date de dépôt: 06.07.2007
(51) Int. Cl.: G01R 31/3187, G01R 31/28, G01R 31/3185, G01R 31/317

(54) **Procédé de test électrique d' un circuit intégré**

(30) Priorité: 25.08.2006 FR 0607504
(71) Demandeur: STMICROELECTRONICS SA, 92120 Montrouge (FR)
(72) Inventeur: Taillet, Francois, 13710 Fuveau (FR)
(74) Mandataire: Marchand, André

(57) **Abrégé**

L'invention concerne un procédé de test d'un circuit intégré (IC) comprenant des étapes de prévision d'au moins une première piste conductrice (A, B) s'étendant le long d'un élément (Pa) du circuit intégré, application d'une tension en un point (A1, A2, B1, B2) de la première piste conductrice, réalisation d'une première mesure de la tension en un point (A1, A2, B1, B2) de la première piste conductrice, et détermination si le circuit intégré est endommagé en fonction du résultat de la première mesure. Application à la détection de dommages dus au sciage ou au test électrique de circuits intégrés.

## Description

La présente invention concerne les circuits intégrés, et en particulier les tests effectués en fin de fabrication d'un circuit intégré.

Ces tests sont généralement effectués à l'aide d'une machine de test qui applique des sondes sur les plages de connexion du circuit intégré. Les sondes se présentent sous la forme d'aiguilles ayant un diamètre d'extrémité distale de l'ordre de quelques micromètres. Les circuits intégrés sont testés les uns après les autres en déplaçant la plaquette semi-conductrice (wafer) sur laquelle sont implantés collectivement les circuits intégrés sous une tête supportant les sondes. Lorsque le wafer est immobile, la tête est déplacée verticalement pour appliquer les sondes sur les plages de connexion d'un circuit intégré, puis retirée du wafer lorsque ce dernier est déplacé. Le positionnement des sondes sur les plages de connexion des circuits intégrés doit être effectué avec une grande précision, faute de quoi, le circuit intégré risque d'être endommagé.

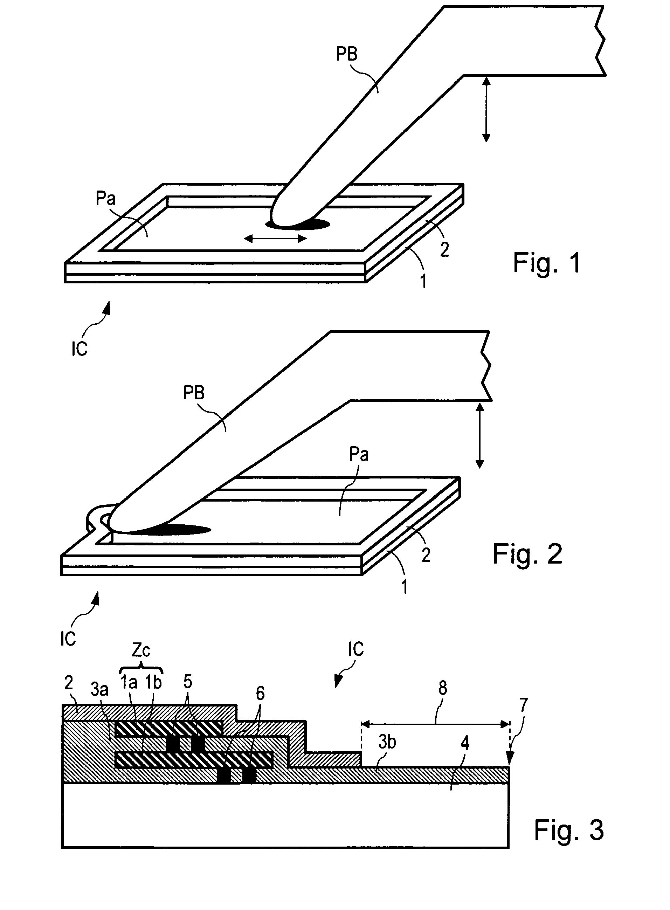

Les figures 1 et 2 représentent en perspective une plage de connexion Pa d'un circuit intégré IC sur laquelle est appliquée une sonde PB. La plage de connexion comprend une couche supérieure électriquement conductrice 1. Le circuit intégré IC est par ailleurs recouvert d'une couche de passivation 2 en un matériau électriquement isolant, tel qu'un polymère ou un verre, recouvrant également les bords des plages de connexion.

La pointe de la sonde PB qui est appliquée sur la plage de connexion Pa est inclinée par rapport à un axe perpendiculaire à la plage de connexion Pa. Il en résulte que lorsque la sonde est abaissée pour être mise en contact avec la plage de connexion, elle se plie légèrement lorsque le mouvement de descente de la sonde est poursuivi après sa mise en contact avec la plage de connexion. Une pression de contact suffisante est ainsi obtenue. Toutefois, puisque l'extrémité proximale de la sonde est fixe, la pointe de la sonde balaye une certaine surface de la plage de connexion Pa durant le mouvement de descente de la tête après contact de la sonde avec la plage de connexion.

Il en résulte, comme cela est illustré sur la figure 2, que si la pointe de la sonde PB entre en contact avec la plage de connexion Pa à proximité d'un bord de celle-ci, la pointe de la sonde aura tendance à arracher partiellement la couche de passivation 2. Il en est de même si la course de descente de la sonde PB est excessive. La pointe de la sonde balaye alors une plus grande surface de la plage de connexion avec une pression excessive, ce qui risque d'endommager la plage de connexion elle-même par écrasement ou arrachement d'une partie de la couche conductrice 1. Il peut en résulter des courts circuits ou des fuites de courant dues à un écrasement des couches du circuit intégré situées sous la plage de connexion. En outre, durant sa course sur la surface de la plage de connexion, la pointe de la sonde peut rencontrer la couche de passivation 2 et risque donc de l'arracher partiellement.

Or la couche de passivation a pour rôle de protéger le circuit intégré de la corrosion et des risques de contamination. Si cette couche est partiellement arrachée, la durée de vie et la fiabilité du circuit intégré peuvent être affectées.

La figure 3 est une vue en coupe d'un bord d'un circuit intégré IC. Sur la figure 3, le circuit intégré IC est réalisé dans une plaquette en un matériau semi-conducteur 4. La face active de la plaquette 4 est recouverte d'une première couche électriquement isolante 3b. Une couche d'un premier plan de métallisation est formée sur la couche électriquement isolante 3b. La couche du premier plan de métallisation comprend une piste électriquement conductrice 1b s'étendant tout autour du circuit intégré IC. Des vias 6 traversent la couche isolante 3b pour connecter la piste conductrice 1b à des zones dopées formées dans le matériau semi-conducteur 4. Une autre couche électriquement isolante 3a est formée sur le premier plan de métallisation. Une couche d'un second plan de métallisation est formée sur la couche 3a. La couche du second plan de métallisation comprend une piste électriquement conductrice 1a s'étendant tout autour du circuit intégré IC, au dessus de la piste conductrice 1b. Des vias 5 traversent la couche isolante 3b pour connecter la piste conductrice 1a du second plan de métallisation à la piste conductrice 1b du premier plan de métallisation. L'ensemble des pistes conductrices 1a, 1b forme une ligne de masse de bordure Zc s'étendant tout autour du circuit intégré. La ligne de masse Zc constitue un anneau de blindage électrique et mécanique du circuit intégré.

Le circuit intégré peut comprendre davantage de plans de métallisation. Dans ce cas, la ligne de masse comprend une piste conductrice dans chaque plan de métallisation.

Une couche de passivation 2 recouvre l'ensemble du circuit intégré à l'exception d'une zone de bordure 8 du circuit intégré IC. La zone de bordure 8 correspond à la zone de sciage ou chemin de découpe du wafer pour individualiser les circuits intégrés. Le centre du chemin de découpe est indiqué par la flèche 7.

Une fois que les circuits intégrés implantés sur le wafer sont testés, le wafer est découpé le long des chemins de découpe en microplaquettes comportant chacune un circuit intégré. La largeur des chemins de découpe est typiquement de l'ordre de 80 à 100 µm. Les circuits intégrés sont isolés des chemins de découpe par la ligne de masse Zc qui sert de protection contre les risques de contamination et de corrosion résultant de défauts dans la couche de passivation 2 à la suite du sciage du wafer (pénétration d'impuretés dans le circuit intégré par la tranche).

Les chemins de découpe sont généralement prévus suffisamment larges pour qu'il subsiste une distance suffisante après découpe entre la ligne de masse de bordure et le bord découpé de la microplaquette. Cependant, il peut arriver que l'opération de sciage provoque des fissures dans le matériau semi-conducteur ou dans la couche de passivation 2. Ces fissures affectent l'intégrité de la ligne de masse de bordure qui ne peut alors plus jouer son rôle protecteur. Ces défauts affectent donc également la durée de vie et la fiabilité du circuit intégré.

Les dommages éventuels causés par les sondes durant le test électrique ou durant l'opération de sciage peuvent être détectés par une inspection optique. Si cette inspection est effectuée par des opérateurs, elle n'est pas fiable et relativement coûteuse. Cette détection peut également être effectuée automatiquement par un système à reconnaissance de forme.

Qu'elle soit effectuée manuellement ou automatiquement, cette inspection n'est pas effectuée systématiquement en raison notamment du fait qu'elle nécessite une durée de traitement non négligeable. Il en résulte que des circuits intégrés endommagés peuvent être livrés à des clients.

La présente invention vise à détecter des défauts dans les bords des plages de connexion et dans la bande de contour des circuits intégrés.

Cet objectif est atteint par la prévision d'un procédé de test d'un circuit intégré, comprenant des étapes consistant à :
- prévoir au moins une première piste conductrice,
- appliquer une tension en un point de la première piste conductrice,
- effectuer une mesure de tension en un point de la première piste conductrice, et
- déterminer si le circuit intégré est endommagé en fonction du résultat de la mesure.

Selon un mode de réalisation de l'invention, la première piste conductrice s'étend autour d'un élément du circuit intégré.

Selon un mode de réalisation de l'invention, le procédé comprend des étapes consistant à :
- prévoir une seconde piste conductrice, s'étendant le long de l'élément du circuit intégré,
- effectuer une mesure de tension en un point de la seconde piste conductrice, et
- déterminer si le circuit intégré est endommagé en fonction du résultat de la mesure en un point de la seconde piste conductrice.

Selon un mode de réalisation de l'invention, les première et seconde pistes conductrices sont au moins partiellement superposées.

Selon un mode de réalisation de l'invention, les première et seconde pistes conductrices s'étendent autour de l'élément du circuit intégré.

Selon un mode de réalisation de l'invention, le procédé comprend des étapes consistant à :
- appliquer une tension à l'élément du circuit intégré,
- effectuer une mesure de tension en un point de la seconde piste conductrice, et
- déterminer si le circuit intégré est endommagé en fonction du résultat de la mesure en un point de la seconde piste conductrice.

Selon un mode de réalisation de l'invention, le procédé comprend des étapes consistant à :
- appliquer une tension à l'élément du circuit intégré,
- effectuer une mesure de tension en un point de la première piste conductrice, et
- déterminer si le circuit intégré est endommagé en fonction du résultat de la mesure en un point de la première piste conductrice.

Selon un mode de réalisation de l'invention, l'élément du circuit intégré est une plage de connexion du circuit intégré.

Selon un mode de réalisation de l'invention, l'élément du circuit intégré est une ligne de masse en bordure du circuit intégré.

L'invention concerne également un circuit intégré comprenant au moins une première piste conductrice, et un circuit de test configuré pour :
- appliquer une tension en un point de la première piste conductrice,
- effectuer une mesure de tension en un point de la première piste conductrice, et
- déterminer si le circuit intégré est endommagé en fonction du résultat de la mesure.

Selon un mode de réalisation de l'invention, la première piste conductrice s'étend autour d'un élément du circuit intégré.

Selon un mode de réalisation de l'invention, le circuit intégré comprend une seconde piste conductrice, le circuit de test étant configuré pour :
- effectuer une mesure de tension en un point de la seconde piste conductrice, et
- déterminer si le circuit intégré est endommagé en fonction du résultat de la mesure en un point de la seconde piste conductrice.

Selon un mode de réalisation de l'invention, les première et seconde pistes conductrices sont au moins partiellement superposées.

Selon un mode de réalisation de l'invention, les première et seconde pistes conductrices s'étendent autour de l'élément du circuit intégré.

Selon un mode de réalisation de l'invention, le circuit de test est configuré pour :
- appliquer une tension à l'élément du circuit intégré,
- effectuer une mesure de tension en un point de la seconde piste conductrice, et
- déterminer si le circuit intégré est endommagé en fonction du résultat de la mesure en un point de la seconde piste conductrice.

Selon un mode de réalisation de l'invention, le circuit de test est configuré pour :
- appliquer une tension à l'élément du circuit intégré,
- effectuer une mesure de tension en un point de la première piste conductrice, et
- déterminer si le circuit intégré est endommagé en fonction du résultat de la mesure en un point de la première piste conductrice.

Selon un mode de réalisation de l'invention, l'élément du circuit intégré est une plage de connexion du circuit intégré.

Selon un mode de réalisation de l'invention, l'élément du circuit intégré est une ligne de masse en bordure du circuit intégré.

Selon un mode de réalisation de l'invention, les pistes conductrices sont formées dans des plans de métallisation dans lesquels l'élément est formé.

Ces objets, caractéristiques et avantages ainsi que d'autres de la présente invention seront exposés plus en détail dans la description suivante d'un mode de réalisation de l'invention, faite à titre non limitatif en relation avec les figures jointes parmi lesquelles :
- les figures 1 et 2 décrites précédemment sont des vues en perspective d'une plage de connexion d'un circuit intégré,
- la figure 3 déjà décrite est une vue en coupe transversale du bord d'un circuit intégré,
- les figures 4 et 5 sont des vues de dessus et en coupe transversale d'une plage de connexion d'un circuit intégré, selon un mode de réalisation de l'invention,
- la figure 6 est une vue en coupe transversale du bord d'un circuit intégré selon un mode de réalisation de l'invention,
- la figure 7 représente un circuit de détection de défauts selon un mode de réalisation de l'invention, connecté à une plage de connexion du circuit intégré,
- la figure 8 représente le circuit de détection de défauts connecté à des pistes conductrices de bordure du circuit intégré,
- la figure 9 représente un circuit de test du circuit intégré, selon un mode de réalisation de l'invention,
- la figure 10 est un schéma électrique d'un circuit du circuit de test représenté sur la figure 9.

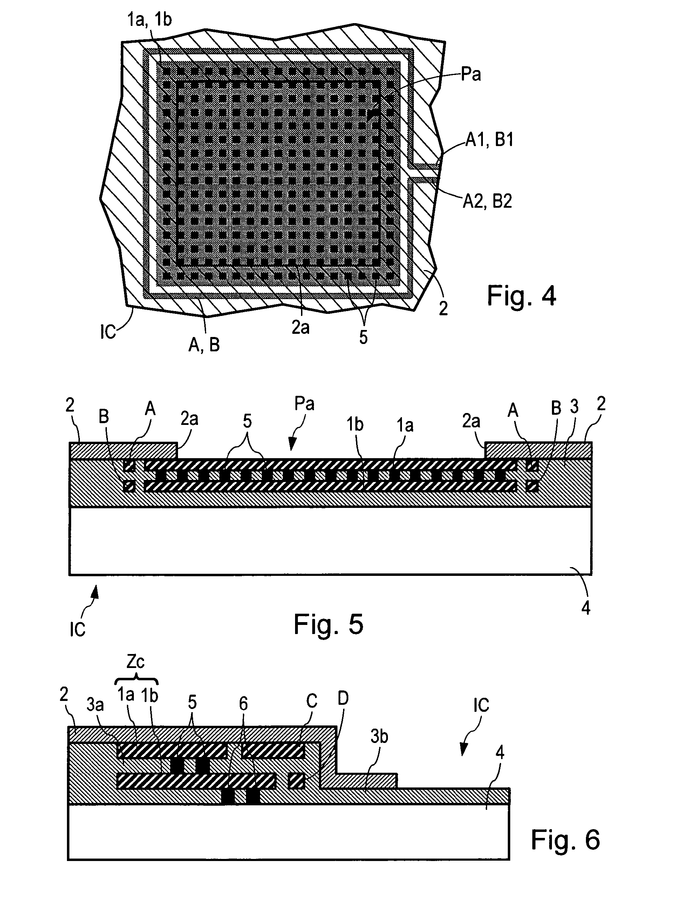

Les figures 4 et 5 représentent une plage de connexion Pa d'un circuit intégré IC selon un mode de réalisation de l'invention. Le circuit intégré IC est réalisé dans une plaquette en un matériau semi-conducteur 4 dont la face active est recouverte d'une couche électriquement isolante 3, par exemple en silice. La plage de connexion Pa est formée dans la couche 3 par deux couches métalliques 1a, 1b superposées, appartenant à deux plans de métallisation, et reliées entre elles par des vias 5 répartis selon une configuration matricielle en lignes et en colonnes. La couche 3 est recouverte d'une couche de passivation 2 recouvrant également le bord de la plage de connexion Pa.

Selon un mode de réalisation de l'invention, chaque couche métallique 1a, 1b formant la plage de connexion Pa est entourée par une piste électriquement conductrice A, B. Les extrémités de chaque piste conductrice A, B sont connectées à un circuit de détection qui sera décrit plus loin.

Si une sonde PB a endommagé la couche de passivation 2 au dessus du bord de la plage conductrice Pa, elle peut avoir également coupé la piste conductrice A ou B. La sonde peut également avoir arraché une partie de la plage conductrice qui se trouve alors en contact avec la piste conductrice A ou B. Elle peut également avoir écrasé la couche isolante 3, mettant les pistes A et B en contact électrique.

Un défaut peut donc être détecté en vérifiant la continuité électrique entre les extrémités de chacun des conducteurs A et B, ou l'absence de continuité électrique entre la plage de connexion Pa et l'une ou l'autre des pistes conductrices A et B, ou encore l'absence de continuité électrique entre les pistes conductrices A et B.

La figure 6 représente la bordure d'un circuit intégré IC. Sur la figure 6, le circuit intégré IC est réalisé dans une plaquette en un matériau semi-conducteur 4. La face active de la plaquette 4 est recouverte d'une première couche électriquement isolante 3b. Une couche d'un premier plan de métallisation est formée sur la couche électriquement isolante 3b. La couche du premier plan de métallisation comprend une piste électriquement conductrice 1b s'étendant tout autour du circuit intégré IC. Des vias 6 traversent la couche isolante 3b pour connecter la piste conductrice 1b à des zones dopées formées dans le matériau semi-conducteur 4. Une autre couche électriquement isolante 3a est formée sur le premier plan de métallisation. Une couche d'un second plan de métallisation est formée sur la couche 3a. La couche du second plan de métallisation comprend une piste électriquement conductrice 1a s'étendant tout autour du circuit intégré IC, au dessus de la piste conductrice 1b. Des vias 5 traversent la couche isolante 3b pour connecter les zones 1a du second plan de métallisation aux zones 1b du premier plan de métallisation. L'ensemble des zones 1a, 1b forme une ligne de masse de bordure Zc s'étendant tout autour du circuit intégré.

Le circuit intégré peut comprendre davantage de plans de métallisation. Dans ce cas, la ligne de masse comprend une piste conductrice dans chaque plan de métallisation.

Une couche de passivation 2 recouvre l'ensemble du circuit intégré à l'exception d'une zone de bordure 8 du circuit intégré IC.

Selon un mode de réalisation de l'invention, chaque piste conductrice 1a, 1b est entourée d'une piste conductrice C, D formée dans le même plan de métallisation. Les pistes conductrices C, D sont superposées, la piste conductrice supérieure étant recouverte par la couche de passivation 2.

Avantageusement, la piste conductrice supérieure C est plus large que la piste conductrice D et recouvre à la fois cette dernière et le bord de la piste conductrice 1b appartenant au même plan de métallisation que la piste conductrice D.

Si le sciage du circuit intégré a endommagé la couche de passivation 2, il peut avoir également coupé la piste conductrice C ou D. Le sciage du circuit intégré peut également avoir écrasé la couche isolante 3a et ainsi avoir mis en contact les pistes conductrices C et D, ou les pistes conductrices C et 1b.

Un défaut résultant du sciage peut donc être détecté en vérifiant la continuité électrique entre les extrémités de chacun des conducteurs C et D, ou l'absence de continuité électrique entre les pistes conductrices C et D, ou encore l'absence de continuité électrique entre des zones conductrices des plans de métallisation 1a, 1b et l'une ou l'autre des pistes conductrices C et D.

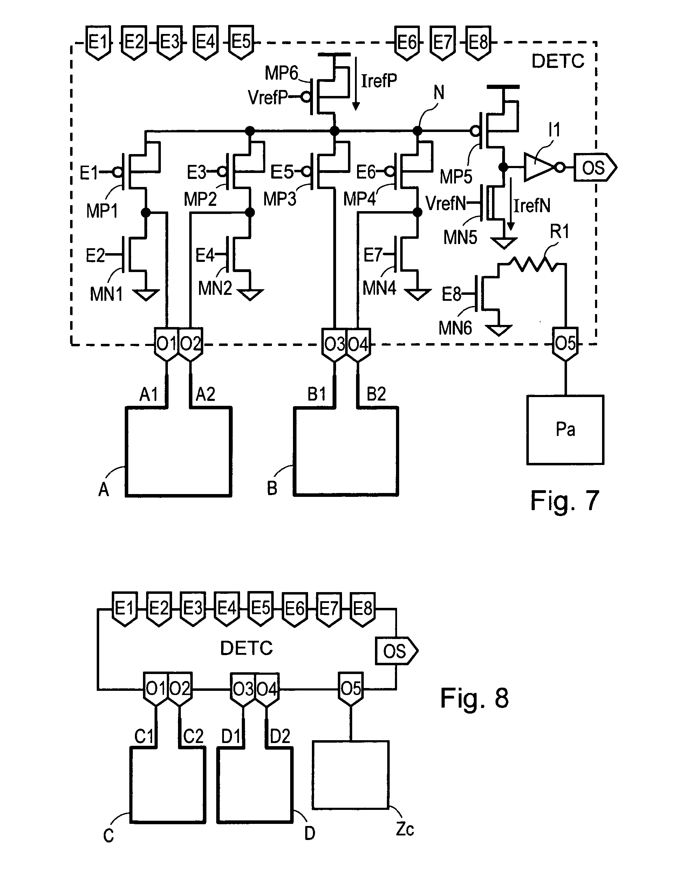

Les figures 7 et 8 représentent un circuit de détection DETC prévu dans le circuit intégré pour une plage de connexion Pa ou la ligne de masse de bordure Zc. Le circuit de détection DETC comprend des entrées de signaux de commande E1 à E8, des sorties O1 à 05 prévues pour être connectées aux extrémités des pistes conductrices A, B ou C, D et à une zone conductrice 1 (plage de connexion Pa ou ligne de masse de bordure Zc du circuit intégré) et une sortie de signal de résultat de détection OS.

Sur la figure 7, les sorties O1 et O2 sont connectées aux extrémités A1, A2 de la piste conductrice A, les sorties 03 et 04 sont connectées aux extrémités B1, B2 de la piste conductrice B, et la sortie 05 est connectée à une plage de connexion Pa du circuit intégré IC.

Sur la figure 8, les sorties O1 et O2 sont connectées aux extrémités C1, C2 de la piste conductrice C, les sorties 03 et 04 sont connectées aux extrémités D1, D2 de la piste conductrice D, et la sortie 05 est connectée à la ligne de masse de contour Zc du circuit intégré IC.

Sur la figure 7, le circuit DETC comporte un premier étage comprenant un transistor MOS à canal P MP1 et un transistor MOS à canal N MN1 dont la source est connectée à la masse. Le drain du transistor MP1 est connecté au drain du transistor MN1, ainsi qu'à la sortie O1 (destinée à être connectée à l'extrémité A1 ou C1 de la piste conductrice A ou C). La grille du transistor MP1 est connectée à l'entrée E1. La grille du transistor MN1 est connectée à l'entrée E2.

Le circuit DETC comporte un second étage comprenant un transistor MOS à canal P MP2 et un transistor MOS à canal N MN2 dont la source est connectée à la masse. Le drain du transistor MP2 est connecté au drain du transistor MN2, ainsi qu'à la sortie 02 (destinée à être connectée à l'extrémité A2 ou C2 de la piste conductrice A ou C). La grille du transistor MP2 est connectée à l'entrée E3. La grille du transistor MN2 est connectée à l'entrée E4.

Le circuit DETC comporte un troisième étage comprenant un transistor MOS à canal P MP3. Le drain du transistor MP3 est connecté à la sortie 03 (destinée à être connectée à l'extrémité B1 ou D1) de la piste conductrice B ou D). La grille du transistor MP3 est connectée à l'entrée E5.

Le circuit DETC comporte un quatrième étage comprenant un transistor MOS à canal P MP4 et un transistor MOS à canal N MN4 dont la source est connectée à la masse. Le drain du transistor MP4 est connecté au drain du transistor MN4, ainsi qu'à la sortie 04 (destinée à être connectée à l'extrémité B2 ou D2) de la piste conductrice B ou D). La grille du transistor MP4 est connectée à l'entrée E6. La grille du transistor MN4 est connectée à l'entrée E7.

Le circuit DETC comprend un transistor MOS à canal N MN6 dont la source est connectée à la masse. Le drain du transistor MP4 est relié par l'intermédiaire d'une résistance R1 à la sortie 05 (destinée à être connectée à la plage de connexion Pa ou la ligne de masse de bordure Zc). La grille du transistor MN6 est connectée à l'entrée E8 du circuit de détection.

La résistance R1 permet de protéger le transistor MN6 contre les décharges électrostatiques (ESD), mais n'a pas de rôle actif dans le fonctionnement du circuit. Sa valeur est de l'ordre du Kilo Ohm. Elle doit rester suffisamment faible pour que le potentiel de la sortie 05 reste proche de celui de la masse, lorsque le transistor MN6 est passant et qu'une fuite est détectée entre la plage de connexion PA et les pistes conductrices A ou B (R1 x IrefP doit rester faible, par exemple R1 = 1 kOhm et Irefp = 10µA).

Le circuit DETC comporte un étage de sortie comprenant un transistor MOS à canal P MP5, un transistor MOS à canal N MN5 dont la source est connectée à la masse, et un inverseur I1. Le drain du transistor MP5 est connecté au drain du transistor MN5, ainsi qu'à l'entrée d'un inverseur I1. La source du transistor MP5 reçoit la tension d'alimentation du circuit intégré. La grille du transistor MP5 est connectée à un noeud N auquel sont connectées les sources des transistors MP1, MP2, MP3 et MP4. La grille du transistor MN5 est commandée par une tension de référence VrefN, de manière à ce que le courant IrefN traversant le transistor MN5 soit constant. La sortie de l'inverseur I1 est connectée à la sortie OS du circuit de détection.

Le circuit DETC comprend un transistor MOS à canal P MP6 dont la source reçoit la tension d'alimentation du circuit intégré, et le drain est connecté au noeud N. La grille du transistor MP6 est commandée par une tension de référence VrefP, de manière à ce que le courant IrefP traversant le transistor MP6 soit constant.

Les transistors commandés par les signaux d'entrée E1-E8 sont utilisés comme des interrupteurs pour connecter les sorties O1-O4 à la masse ou à la source de tension d'alimentation du circuit intégré, et la sortie 05 à la masse, afin d'effectuer des tests de conduction électrique. L'étage de sortie bascule sensiblement dès que le potentiel du noeud N est proche de la tension de seuil de conduction du transistor MP5.

Le tableau suivant résume pour chaque test susceptible d'être effectué par le circuit de détection les valeurs des entrées E1-E8 du circuit de détection et la valeur du signal de sortie OS si un défaut est détecté.

**Tableau 1**

| TEST | Type de Test | | E1 | E2 | E3 | E4 | E5 | E6 | E7 | E8 | os |
|---|---|---|---|---|---|---|---|---|---|---|---|
| 0 | Circuit ouvert | O1 - O3 | 1 | 1 | 1 | 0 | 0 | 1 | 0 | 0 | 0 |
| 1 | | O2 - O4 | 1 | 0 | 1 | 1 | 1 | 0 | 0 | 0 | 0 |
| 2 | | O1 - O5 | 0 | 0 | 1 | 0 | 1 | 1 | 0 | 1 | 0 |
| 3 | | O2 - O5 | 1 | 0 | 0 | 0 | 1 | 1 | 0 | 1 | 0 |
| 4 | | O3 - O5 | 1 | 0 | 1 | 0 | 0 | 1 | 0 | 1 | 0 |
| 5 | | O4 - O5 | 1 | 0 | 1 | 0 | 1 | 0 | 0 | 1 | 0 |
| 6 | Continuité électrique | O1 - O2 | 0 | 0 | 1 | 1 | 1 | 1 | 0 | 0 | 1 |
| 7 | | O3 - O4 | 1 | 0 | 1 | 0 | 0 | 1 | 1 | 1 | 1 |

Tests 0 et 1 : absence de continuité électrique entre deux pistes conductrices superposées A et B (ou C et D)

Dans les tests 0 et 1, la sortie 05 est placée à un potentiel flottant (transistor MN6 non passant). La plage de connexion Pa (ou la ligne de masse de contour Zc) est donc placée à un potentiel flottant.

Dans le test 0, le transistor MP1 du premier étage est commandé non passant, et le transistor MN1 de cet étage est commandé passant. Il en résulte que la sortie O1 est mise à la masse. Dans le second étage, le transistors MP2 et MN2 sont commandés non passants. La sortie 02 se trouve donc à un potentiel flottant. Dans le troisième étage, le transistor MP3 est commandé passant. La sortie 03 est donc à 1 (à la tension d'alimentation). Dans le quatrième étage, les transistors MP4 et MN4 sont commandés non passants. Il en résulte que la sortie 04 est placée à un potentiel flottant.

S'il y a un court-circuit entre les sorties O1 et 03, c'est-à-dire entre les extrémités A1 et B1 (ou C1 et D1) des pistes conductrices A et B (ou C et D), la sortie 03 est mise à la masse au lieu d'être à 1, et donc la sortie OS du circuit de détection est à 0. Dans le cas contraire, la sortie OS est à 1.

Dans le test 1, les transistors MP1 et MN1 du premier étage sont commandés non passants. Il en résulte que la sortie O1 est mise à un potentiel flottant. Dans le second étage, le transistor MP2 est commandé non passant, et le transistor MN2 est commandé passant. La sortie 02 se trouve donc à la masse. Dans le troisième étage, le transistor MP3 est commandé non passant. La sortie 03 est donc placée à un potentiel flottant. Dans le quatrième étage, le transistor MP4 est commandé passant et le transistor MN4 est commandé non passant. Il en résulte que la sortie 04 est mise à 1.

S'il y a un court-circuit entre les sorties 02 et 04, c'est-à-dire entre les extrémités A2 et B2 (ou C2 et D2) des pistes conductrices A et B (ou C et D), la sortie 04 est à la masse au lieu d'être à 1, et donc la sortie OS du circuit de détection est à 0. Dans le cas contraire, la sortie OS est à 1.

Tests 2 à 5 : absence de continuité électrique entre une piste conductrice A et B (ou C et D) et la plage de connexion Pa (ou la ligne de masse de contour Zc)

Dans les tests 2 à 5, la sortie 05 est placée à la masse (transistor MN6 passant). La plage de connexion Pa (ou la ligne de masse de contour Zc) est donc placée à la masse.

Dans le test 2, le transistor MP1 du premier étage est commandé passant, et le transistor MN1 de cet étage est commandé non passant. Il en résulte que la sortie O1 est mise à 1. Dans le second étage, les transistors MP2 et MN2 sont commandés non passants. La sortie 02 se trouve donc à un potentiel flottant. Dans le troisième étage, le transistor MP3 est commandé non passant. La sortie 03 est donc à un potentiel flottant. Dans le quatrième étage, les transistors MP4 et MN4 sont commandés non passants. Il en résulte que la sortie 04 est placée à un potentiel flottant.

S'il y a un court-circuit entre les sorties O1 et 05, c'est-à-dire entre l'extrémité A1 (ou C1) des pistes conductrices A (ou C) et la plage de connexion Pa (ou la ligne de masse de contour Zc), la sortie O1 est mise à la masse au lieu d'être à 1, et donc la sortie OS du circuit de détection est à 0. Dans le cas contraire, la sortie OS est à 1.

Dans le test 3, les transistors MP1 et MN1 du premier étage sont commandés non passants. Il en résulte que la sortie O1 est placée à un potentiel flottant. Dans le second étage, le transistor MP2 est commandé passant, et le transistor MN2 est commandé non passant. La sortie 02 se trouve donc mise à 1. Dans le troisième étage, le transistor MP3 est commandé non passant. La sortie 03 est donc mise à un potentiel flottant. Dans le quatrième étage, les transistors MP4 et MN4 sont commandés non passants. Il en résulte que la sortie 04 est placée à un potentiel flottant.

S'il y a un court-circuit entre les sorties 02 et 05, c'est-à-dire entre l'extrémité A2 (ou C2) des pistes conductrices A (ou C) et la plage de connexion Pa (ou la ligne de masse de contour Zc), la sortie 02 est mise à la masse au lieu d'être à 1, et donc la sortie OS du circuit de détection est à 0. Dans le cas contraire, la sortie OS est à 1.

Dans le test 4, les transistors MP1 et MN1 du premier étage sont commandés non passants. Il en résulte que la sortie O1 est placée à un potentiel flottant. Dans le second étage, les transistors MP2 et MN2 sont commandés non passants. La sortie 02 se trouve donc à un potentiel flottant. Dans le troisième étage, le transistor MP3 est commandé passant. La sortie 03 est donc mise à 1. Dans le quatrième étage, les transistors MP4 et MN4 sont commandés non passants. Il en résulte que la sortie 04 est placée à un potentiel flottant.

S'il y a un court-circuit entre les sorties 03 et 05, c'est-à-dire entre l'extrémité B1 (ou D1) des pistes conductrices B (ou D) et la plage de connexion Pa ou la ligne de masse de contour Zc, la sortie 03 est mise à la masse au lieu d'être à 1, et donc la sortie OS du circuit de détection est à 0. Dans le cas contraire, la sortie OS est à 1.

Dans le test 5, les transistors MP1 et MN1 du premier étage sont commandés non passants. Il en résulte que la sortie O1 est placée à un potentiel flottant. Dans le second étage, les transistors MP2 et MN2 sont commandés non passants. La sortie 02 se trouve donc à un potentiel flottant. Dans le troisième étage, le transistor MP3 est commandé non passant. La sortie 03 est donc à un potentiel flottant. Dans le quatrième étage, le transistor MP4 est commandé passant, et le transistor MN4 est commandé non passant. Il en résulte que la sortie 04 est mise à 1.

S'il y a un court-circuit entre les sorties 04 et 05, c'est-à-dire entre l'extrémité B2 (ou D2) des pistes conductrices B (ou D) et la plage de connexion Pa ou la ligne de masse de contour Zc, la sortie 04 est mise à la masse au lieu d'être à 1, et donc la sortie OS du circuit de détection est à 0. Dans le cas contraire, la sortie OS est à 1.

Tests 6 et 7 : continuité électrique entre les extrémités de la piste conductrice A ou B (ou C ou D)

Dans les tests 6 et 7, la sortie O5 est placée à un potentiel flottant (transistor MN6 non passant). La plage de connexion Pa (ou la ligne de masse de contour Zc) est donc placée à un potentiel flottant.

Dans le test 6, le transistor MP1 du premier étage est commandé passant, et le transistor MN1 est commandé non passant. Il en résulte que la sortie O1 est mise à 1. Dans le second étage, le transistor MP2 est commandé non passant, et le transistor MN2 est commandé passant. La sortie 02 se trouve donc mise à la masse. Dans le troisième étage, le transistor MP3 est commandé non passant. La sortie 03 est donc à un potentiel flottant. Dans le quatrième étage, les transistors MP4 et MN4 sont commandés non passants. Il en résulte que la sortie 04 est placée à un potentiel flottant.

S'il y a une continuité électrique entre les sorties O1 et 02, c'est-à-dire entre les extrémités A1 et A2 (ou C1 et C2) de la piste conductrice A (ou C), la sortie O1 est mise à la masse au lieu d'être à 1, et donc la sortie OS du circuit de détection est à 0. Dans le cas contraire, la sortie OS est à 1.

Dans le test 7, les transistors MP1 et MN1 du premier étage sont commandés non passants. La sortie O1 est donc mise à un potentiel flottant. Dans le second étage, les transistors MP2 et MN2 sont commandés non passants. La sortie 02 se trouve donc à un potentiel flottant. Dans le troisième étage, le transistor MP3 est commandé passant. La sortie 03 est donc mise à 1. Dans le quatrième étage, le transistor MP4 est commandé non passant, et le transistor MN4 est commandé passant. Il en résulte que la sortie 04 est mise à la masse.

S'il y a une continuité électrique entre les sorties 03 et 04, c'est-à-dire entre les extrémités B1 et B2 (ou D1 et D2) de la piste conductrice B (ou D), la sortie 03 est mise à la masse au lieu d'être à 1, et donc la sortie OS du circuit de détection est à 0. Dans le cas contraire, la sortie OS est à 1.

Bien entendu, les tests ne sont pas nécessairement effectués dans l'ordre spécifié dans le tableau. Ainsi, par exemple si les tests 6 et 7 sont effectués en premier, et que les pistes conductrices A et B (ou C et D) ainsi testées ne comportent pas de coupure, les tests 0 et 1 sont équivalents. Il en est de même des tests 2 et 3, ainsi que des tests 4 et 5. Seuls les tests 0, 2 et 4 (ou 1, 3, 5) sont donc nécessaires.

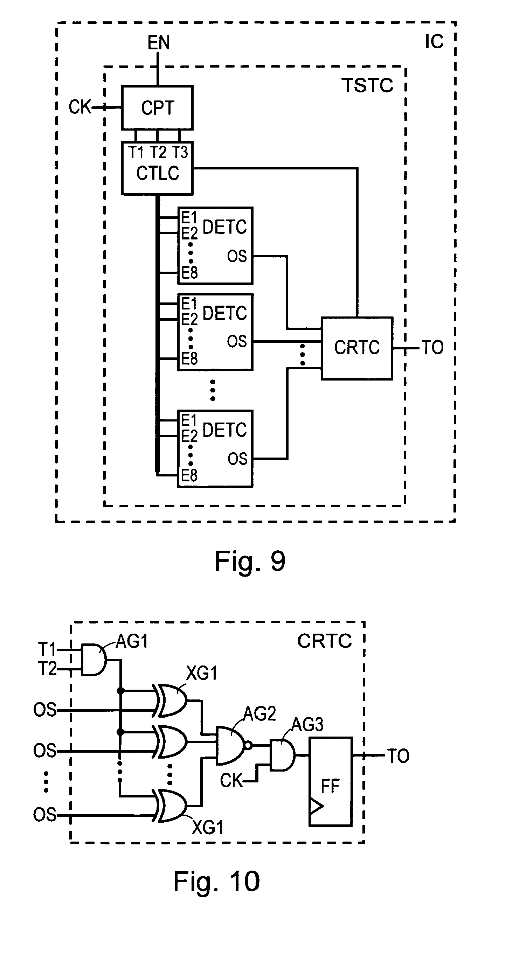

La figure 9 représente un circuit de test TSTC du circuit intégré IC. Le circuit de test TSTC comprend une pluralité de circuits de détection DETC, tels que celui décrit en référence à la figure 7, à raison de un circuit de détection pour chaque plage de test et pour le contour du circuit intégré. Les entrées des circuits DETC sont connectées à un circuit de contrôle CTLC conçu pour générer les signaux E1-E8 conformément à l'un des tests 0 à 7 répertoriés dans le tableau 1, en fonction de signaux de commande T1, T2, T3 permettant de sélectionner l'un des tests 0 à 7. Les sorties respectives de chacun des circuits de détection DETC sont connectées à un circuit de consolidation des résultats des tests CRTC qui fournit un signal de résultat de test TO à 0 ou à 1 selon que l'un des circuits DETC a détecté ou non un défaut au cours de l'un des tests 0 à 7. Le signal TO est par exemple fourni sur une borne de test du circuit intégré.

Les signaux T1, T2, T3 sont fournis par un compteur CPT de 0 à 7, cadencé par un signal d'horloge CK du circuit intégré IC. La machine d'état est déclenchée par un signal d'activation EN fourni par exemple de l'extérieur du circuit intégré par une borne de test.

Alternativement les signaux T1, T2, T3 sont fournis par un dispositif de test externe au circuit intégré IC par l'intermédiaire de bornes de test. Cette solution présente l'avantage de permettre de déterminer lorsqu'un test a échoué quel est le test concerné.

Lorsque les plages de connexion sont des connexions de sortie ou d'entrée/sortie, il peut être prévu un circuit additionnel permettant de mettre la plage de connexion en haute impédance pendant l'exécution des tests.

La figure 10 représente un exemple du circuit de consolidation des résultats des tests CRTC. Le circuit CRTC comprend une porte logique AG1 de type ET recevant en entrée les signaux T1, T2 fournis par le compteur CPT. Le circuit CRTC comprend des portes logiques XG1 de type OU exclusif recevant en entrée le signal de sortie de la porte AG1 et un signal de sortie OS des circuits de détection DETC. La sortie de chacune des portes XG1 est connectée à une entrée d'une porte logique AG2 de type ET inversée. La sortie de la porte AG2 est connectée à l'entrée d'une porte logique AG3 de type ET dont une autre entrée reçoit le signal d'horloge CK. La sortie de la porte AG3 est connectée à l'entrée d'une bascule FF de type RS dont la sortie fournit le signal de résultat de test TO.

La porte AG1 fournit un signal à 1 lorsque le numéro de test est égal à 6 ou 7. Les portes XG1 permettent d'inverser les signaux de sortie OS des circuits DETC pour les tests 6 et 7. La porte AG2 fournit un signal à 1 si l'un des tests effectués par les circuits de détection a échoué. La porte AG3 permet de conditionner le signal de sortie de la porte AG2 en fonction du signal d'horloge CK, en supposant que les signaux T1, T2 et T3 sont stables le signal CK est à 1. En effet, pendant les changements d'état du compteur, des aléas logiques peuvent créer de états interdits transitoires sur les entrées E1-E8, et donc induire une fausse détection d'erreur. La bascule FF permet de mémoriser le passage à 1 du signal de sortie de la porte AG2.

Il apparaîtra clairement à l'homme de l'art que la présente invention est susceptible de diverses variantes de réalisation et d'applications. En particulier, l'invention n'est pas limitée à des pistes conductrices de test s'étendant autour des plages de connexion du circuit intégré. Il peut être envisagé une piste conductrice s'entendant uniquement le long d'un, deux ou trois côtés de la plage conductrice, notamment si les circuits intégrés sont toujours présentés face à la tête de test avec la même orientation.

Il n'est pas non plus indispensable de prévoir une piste conductrice de test pour chacun des plans de métallisation constituant la plage de connexion ou la ligne de masse de contour. Une seule piste conductrice peut en effet être prévue.

Il n'est pas non plus indispensable de connecter le circuit de détection aux extrémités des pistes conductrices.

Certains tests indiqués dans le tableau 1 peuvent être omis, le tableau donnant la liste de tous les tests possibles, compte tenu des pistes conductrices de test prévues.

La présente invention ne s'applique pas uniquement au test de circuits intégrés. Ainsi elle peut s'appliquer par exemple à la détection de corrosion. A cet effet, le circuit de détection DETC est connecté à une bande métallique sensible à la corrosion, formée sur le circuit intégré, par exemple visible au travers d'une fenêtre.

La présente invention peut également être appliquée pour réaliser une puce jetable après désactivation. A cet effet, la piste conductrice connectée au circuit de détection peut comprendre une bande métallique susceptible d'être accessible à l'aide d'un outil, le signal de sortie du circuit de détection étant utilisé pour désactiver le circuit intégré. Dans ces deux exemples d'application, le circuit de détection DETC est alors actif durant toute la durée de vie du circuit intégré.

## Revendications

1. Procédé de test d'un circuit intégré (IC),
**caractérisé en ce qu'**il comprend des étapes consistant à :
- prévoir au moins une première piste conductrice (A, B, C, D),
- appliquer une tension en un point (A1, A2, B1, B2, C1, C2, D1, D2) de la première piste conductrice,
- effectuer une mesure de tension en un point (A1, A2, B1, B2, C1, C2, D1, D2) de la première piste conductrice, et
- déterminer si le circuit intégré est endommagé en fonction du résultat de la mesure.

2. Procédé selon la revendication 1, dans lequel la première piste conductrice (A, B, C, D) s'étend autour d'un élément (Pa, Zc) du circuit intégré.

3. Procédé selon la revendication 2, comprenant des étapes consistant à :
- prévoir une seconde piste conductrice (A, B, C, D), s'étendant le long de l'élément (Pa, Zc) du circuit intégré (IC),
- effectuer une mesure de tension en un point (A1, A2, B1, B2, C1, C2, D1, D2) de la seconde piste conductrice, et
- déterminer si le circuit intégré est endommagé en fonction du résultat de la mesure en un point de la seconde piste conductrice.

4. Procédé selon la revendication 3, dans lequel les première et seconde pistes conductrices (A, B ; C, D) sont au moins partiellement superposées.

5. Procédé selon la revendication 3 et 4, dans lequel les première et seconde pistes conductrices (A, B ; C, D) s'étendent autour de l'élément (Pa, Zc) du circuit intégré (IC).

6. Procédé l'une des revendications 3 à 5, comprenant des étapes consistant à :
- appliquer une tension à l'élément (Pa, Zc) du circuit intégré (IC),
- effectuer une mesure de tension en un point de la seconde piste conductrice (A1, A2, B1, B2, C1, C2, D1, D2), et
- déterminer si le circuit intégré est endommagé en fonction du résultat de la mesure en un point de la seconde piste conductrice.

7. Procédé l'une des revendications 2 à 6, comprenant des étapes consistant à :
- appliquer une tension à l'élément (Pa, Zc) du circuit intégré (IC),
- effectuer une mesure de tension en un point (A1, A2, B1, B2, C1, C2, D1, D2) de la première piste conductrice (A, B, C, D), et
- déterminer si le circuit intégré est endommagé en fonction du résultat de la mesure en un point de la première piste conductrice.

8. Procédé selon l'une des revendications 1 à 7, dans lequel l'élément du circuit intégré (IC) est une plage de connexion (Pa) du circuit intégré.

9. Procédé selon l'une des revendications 1 à 8, dans lequel l'élément du circuit intégré (IC) est une ligne de masse (Zc) en bordure du circuit intégré.

10. Circuit intégré (IC),
**caractérisé en ce qu'**il comprend au moins une première piste conductrice (A, B, C, D), et un circuit de test (DETC) configuré pour :
- appliquer une tension en un point (A1, A2, B1, B2, C1, C2, D1, D2) de la première piste conductrice,
- effectuer une mesure de tension en un point (A1, A2, B1, B2, C1, C2, D1, D2) de la première piste conductrice, et
- déterminer si le circuit intégré est endommagé en fonction du résultat de la mesure.

11. Circuit intégré selon la revendication 10, dans lequel la première piste conductrice (A, B, C, D) s'étend autour d'un élément (Pa, Zc) du circuit intégré.

12. Circuit intégré selon la revendication 11, comprenant une seconde piste conductrice (A, B, C, D), le circuit de test (DETC) étant configuré pour :
- effectuer une mesure de tension en un point (A1, A2, B1, B2, C1, C2, D1, D2) de la seconde piste conductrice, et
- déterminer si le circuit intégré est endommagé en fonction du résultat de la mesure en un point de la seconde piste conductrice.

13. Circuit intégré selon la revendication 12, dans lequel les première et seconde pistes conductrices (A, B ; C, D) sont au moins partiellement superposées.

14. Circuit intégré selon l'une des revendications 12 et 13, dans lequel les première et seconde pistes conductrices (A, B ; C, D) s'étendent autour de l'élément (Pa, Zc) du circuit intégré (IC).

15. Circuit intégré selon l'une des revendications 12 à 14, dans lequel le circuit de test (DETC) est configuré pour :
- appliquer une tension à l'élément (Pa, Zc) du circuit intégré,
- effectuer une mesure de tension en un point (A1, A2, B1, B2, C1, C2, D1, D2) de la seconde piste conductrice (A, B, C, D), et
- déterminer si le circuit intégré est endommagé en fonction du résultat de la mesure en un point de la seconde piste conductrice.

16. Circuit intégré selon l'une des revendications 11 à 15, dans lequel le circuit de test (DETC) est configuré pour :
- appliquer une tension à l'élément (Pa, Zc) du circuit intégré,
- effectuer une mesure de tension en un point (A1, A2, B1, B2, C1, C2, D1, D2) de la première piste conductrice (A, B, C, D), et
- déterminer si le circuit intégré est endommagé en fonction du résultat de la mesure en un point de la première piste conductrice.

17. Circuit intégré selon l'une des revendications 10 à 16, dans lequel l'élément du circuit intégré est une plage de connexion (Pa) du circuit intégré.

18. Circuit intégré selon l'une des revendications 10 à 17, dans lequel l'élément du circuit intégré est une ligne de masse (Zc) en bordure du circuit intégré.

19. Circuit intégré selon l'une des revendications 10 à 18, dans lequel les pistes conductrices (A, B, C, D) sont formées dans des plans de métallisation dans lesquels l'élément (Pa, Zc) est formé.
